# EUROPEAN PATENT APPLICATION

(11) **EP 2 941 106 A1**
(43) Date of publication of application: **04.11.2015**
(21) Application number: 14193016.4
(22) Date of filing: 13.11.2014
(51) Int. Cl.: H05K 5/02, G06K 19/077

(54) **Customized electronic device**

(30) Priority: 13.11.2013 NL 2011795; 13.11.2013 NL 2011797
(71) Applicant: Deonet Production B.V., 5652 AM Eindhoven (NL)
(72) Inventor: Van Berkom, Robert Wilhelmina Maria, 5652 AM Eindhoven (NL)
(74) Representative: EP&C

(57) **Abstract**

The invention relates to a method of manufacturing a customized electronic device (1), the electronic device comprising a customized support body (10a) having a customized, attractive shape and a movable electronic part (12), the method comprising:
- providing a support body (10) having a general shape, wherein said support body comprises a recess (14) configured to accommodate the electronic part (12),
- providing the movable electronic part (12), wherein the electronic device (1) comprises a coupling (24) via which the movable electronic part is coupled to the support body, wherein an end of the electronic part is formed as a male connector, wherein the movable electronic part comprises:
o a UDP comprising:
• a flash memory chip and
• an end part comprising metal connector strips,
wherein the flash memory chip and the end part are integrated into a small flat component, and

o an electronic part body (74), which comprises a UDP holding section (98) defining a cavity at one end thereof,

- inserting the movable electronic part into the recess, wherein the male connector (35) is located centrally in the support body,
- cutting the combination of the support body and the electronic part with a cutting device,
the method further comprising cutting different customized forms (25) from a same general combination of a support body (12) and a movable electronic part (10),
characterized in that the method comprises cutting in the electronic part body (74) of the movable electronic part.

## Description

### Field of the invention

The present invention relates to customized electronic devices which have a male connector and are configured to be inserted into a standard port of a computer. The present invention relates in particular to customized USB memory devices. The term "customized electronic devices" is used for electronic devices which have a non-standard, attractive shape which allows the electronic device to be used as a promotional item, a gift, an advertisement tool, a personalized item or as a fashion object. The customized shape of the electronic device may for instance be an animal, a logo, a text, an action figure, a miniature object, a plant or a fantasy figure.

### Background of the invention

Customized electronic devices, in particular customized USB memory devices having a flash memory are known. For instance, custom made USB memory devices are known in the form of a cola bottle, an animal such as a frog or dolphin, a car, a pencil a lollipop. These custom made USB memory devices are highly successful and are widely used as promotional gifts, branding, advertisement tools, etcetera.

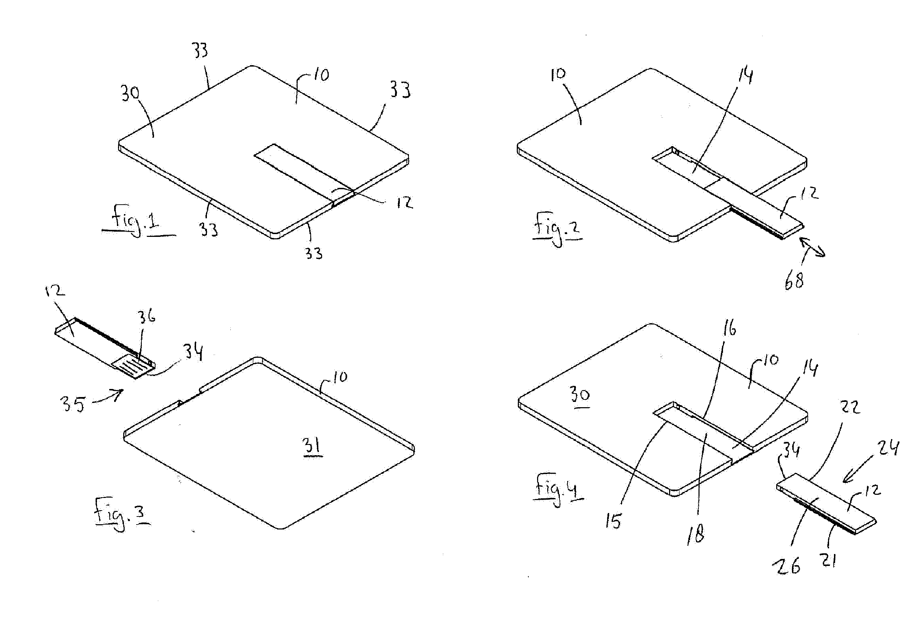

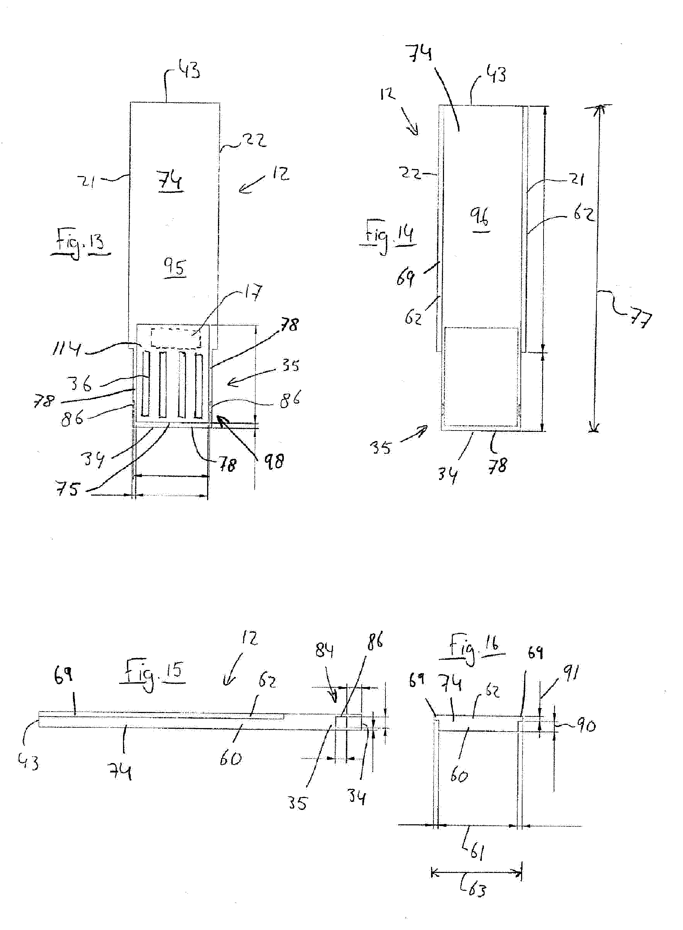

WO2010/076616A1 discloses different embodiments of customized USB sticks. The embodiment of figures 15A-15D shows a chip holder 1400 which is placed in a casing 1300. The casing 1300 with the chip holder 1400 is placed in cardboard halves 20, 30, see figure 1. In use, the chip holder 1400 can be pulled from the casing 1300 by a nail notch 1440 which is accessible via an aperture 1315, see figures 15a and 15d. The aperture and nail notch are essential because without these parts the chip holder 1400 cannot be removed from the casing 1300. A disadvantage of the embodiment of figures 15A-15D is that the available form freedom is limited.

Another disadvantage is that the USB stick has many parts and is relatively complicated. This increases the cost price.

Some other embodiments of WO2010/076616A1 have additional disadvantages besides the limited form freedom or have other disadvantages. The embodiment of figure 1-4 has a limited form freedom and additionally is quite vulnerable because the connector protrudes from the device and can be easily damaged. In the embodiment of figures 5-8 connections between two parts of the device are broken during first use. After the breaking of the connections, there are two loose parts which may become separated and obviously can get lost quite easily. The same applies for the embodiment of figures 9 -10.

EP2645308A2 discloses an USB stick 2 in a protective cover. EP2645308A2 does not relate to a method of producing a customized USB-stick

### The invention

The present invention is based on the insight that a number of existing custom made electronic devices are not very suitable to be produced in relatively small series. This is in particular an obstacle for small companies or private persons who have a desire to use a customized electronic device for promotional purposes. The underlying reason for this is that existing customized electronic devices are made with a customized mould.

In the process of creating such electronic devices, a mould having a special shape is designed and machined. During production, for each product a volume of a rubber or similar material is injected into the mould. Subsequently, the material cures. Next, the resulting shape is removed from the customized mould and merged with the electronic part of the electronic device. Further processing steps may be required such as painting, coating, or attaching a further element to the electronic device.

The difficulty and the drawbacks of these customized electronic devices lies in the use of the customized mould. A customized mould requires substantial costs for design and manufacturing. Flow paths of the rubber or other material in the mould must be calculated, and the customized mould itself is a complex geometrical metal piece which needs to be machined with a very high accuracy. This brings along substantial costs.

For large volumes, the costs of the mould generally do not form an obstacle. However, for small series of customized electronic devices, the costs of the specialized mould are a major obstacle.

This means in practice that custom made electronic devices in small series are often not feasible or attractive due to the high costs. The present invention is based on the insight that this problem occurs and further provides a simple and effective solution to this problem.

The invention provides a method of manufacturing a customized electronic device, in particular an USB memory device, the electronic device comprising a customized support body having a customized, attractive shape and a movable electronic part, the method comprising:
- providing a support body having a general, non-customized shape, wherein said support body comprises a recess configured to accommodate the movable electronic part,
- providing the movable electronic part which fits in the recess, wherein the electronic device comprises a coupling via which the movable electronic part is coupled to the support body, the coupling allowing a movement of the movable electronic part relative to the support body from an inoperative position in which the movable electronic part is inside the recess, to an operative position and vice versa, wherein an end of the electronic part is formed as a male connector constructed to fit in a standard female port of a computer, in particular a female USB port,
   wherein the movable electronic part comprises:
   ∘ a UDP comprising:
      - a flash memory chip and
      - an end part comprising metal connector strips,
      wherein the flash memory chip and the end part are integrated into a small flat component, and
   ∘ an electronic part body, which comprises a UDP holding section defining a cavity at one end thereof, wherein the UDP is positioned in the cavity, and wherein the combined end part of the UDP and the UDP holding section form a male USB connector which fits into a female USB port of a computer, and wherein a length of the cavity is less than 50 percent of a length of the electronic part,
- inserting the movable electronic part into the recess of the support body, wherein the male connector is located centrally in the support body,
- cutting the combination of the support body and the electronic part into a customized form with a cutting device,
the method further comprising manufacturing customized electronic devices having different customized shapes by cutting different customized forms from a same general combination of a support body and a movable electronic part, the method being free of the use of any customized mould for forming the customized form,
characterized in that the method comprises cutting in the electronic part body of the movable electronic part.

The customized electronic device may be a USB memory device, but may for instance also be a wifi dongle or another electronic device which can be plugged into a standard computer port.

An advantage of the present invention is that the combination of the support body and the electronic part which is used in the manufacturing process is common to many different customized electronic devices. In other words, many different customized electronic devices can be made from a same basis, namely the support body having a general shape and the electronic part, which also has a general shape. This is an important factor in cost saving for small series.

The cutting in both the electronic part body of the movable electronic part and the support body having a general, non-customized shape allows a considerable increase in freedom of form relative to the prior art. Basically, any shape can be cut.

In WO2010/076616A1, various embodiments of customized USB sticks are disclosed. The disclosure is limited to cutting in the cardboard halves 20, 30, see page 11. None of the embodiments include cutting in the movable part of the USB device, i.e. the chip holder 1400. The movable part needs to be kept intact for the device to work. In particular because the nail notch 1440 and the aperture 1315 need to be present or otherwise the chip holder cannot be pulled. This considerably limits the forms that can be made. In the present invention the freedom of form is much greater because the cutting also takes place in the electronic part body (74) of the movable electronic part.

Other embodiments of WO2010/076616A1 have the male USB connector on the outer side. This also limits the form in which the device can be cut, because the male USB connector cannot be cut off.

In an embodiment of the present invention, the coupling is a sliding coupling, allowing the electronic part to slide into and out of the recess. The recess may be elongate and may extend from a central portion of the support body to an edge of the support body. The sides of the electronic part and the sides of the recess may be configured to form the sliding coupling, allowing the electronic part to be inserted into the recess into the inoperative position and to be removed from the recess to the operative position. The sides of the electronic part and the sides of the recess comprise a rib and groove which are formed on respectively in the sides and are configured to form the sliding coupling. The male connector forms the first section of the electronic part which is slid into the recess.

In the inoperative position, the entire UDP is in the recess of the support body.

UDP's are known integrated devices which comprise all required electronic parts to act as a USB memory. The present invention uses the UDP to manufacture simple, cost-effective customized USB memory devices having attractive shapes from general parts. This is very cost-efficient.

In an embodiment, the cutting device comprises a punching knife, wherein the support body and the electronic part are flat, and wherein the customized form is punched from the combination of the support body and the inserted electronic part with the punching knife. The punching knife punches through the support body and the electronic part at the same time in a single punching movement, thereby forming the customized form.

It is noted that the cutting operation may also be carried out as two separate cutting steps. Therefore, the step of inserting the electronic part into the support body need not be performed after the cutting step. In this variant, the step of cutting is carried out prior to the step of inserting the electronic part into the support body, and the cutting step comprises a cutting step for the support body and separate a cutting step for the electronic part. Next, the customized electronic part is inserted into the customized support body.

The punching knife allows a very simple, fast, reliable and cost-effective way of manufacturing customized electronic devices. A punching knife is relatively inexpensive to manufacture, in particular when compared with a mould.

A different punching knife is used for each customized form.

The punching knife may punch through the support body and the inserted electronic part at the same time in a single punching movement, thereby forming the customized form.

Other types of cutting operations are also possible, e.g. sawing , cutting with a milling cutter, a laser cutting, cutting with a water jet.

In an embodiment, the coupling is a pivot coupling which allows the electronic part to pivot relative to the support body between an inoperative position wherein the electronic part is substantially flush with the support body and an operative position wherein the electronic part is not flush with the support body and the male connector is directed away from the support body.

The pivot coupling ensures that the support body and the electronic part remain connected to one another, and allows a very easy movement of the electronic part between the inoperative position and the operative position.

In the inoperative position, the electronic part may be flush with the top side and/or the bottom side of the support body.

In an embodiment, each side of the recess is formed as a rail, wherein each side of the electronic part forms a slider which is configured to slide through the rail, wherein the recess has a first, constricted section having a first, constricted width and a second, wider section having a second, greater width, wherein the electronic part has respectively a matching first, constricted section having a first, constricted width and a second, wider section having a wider width, thereby creating a form lock which prevents any movement of the electronic part relative to the support body in a direction which is transverse to a sliding direction.

It was found that this configuration provides a simple and reliable sliding coupling.

In an embodiment, when seen in top view the recess comprises a central part and an outer part, wherein the central part is configured to accommodate the end of the electronic part which forms the male connector. This configuration allows a large freedom of form in the cutting of the support body.

If the electronic device comprises a UDP, the entire UDP may be located quite centrally in the support body. This provides a substantial freedom of form.

The ribs and grooves may only extend along the outer part, the central part being free of any ribs and grooves.

In an embodiment, the support body and the electronic part are flat, and the support body has a greater thickness than the electronic part. The recess in the support body does not extend all the way through the support body, but ends at a bottom wall which covers one side of the recess at least partially. The electronic part is only visible from above but not from below. This embodiment provides an advantage in that the metal connector strips are covered by the bottom wall. The bottom wall need not extend along the entire recess, but may at least cover the metal connector strips.

The present invention further relates to a customized electronic device, in particular a USB memory device, the electronic device comprising:
- a customized support body having a customized, attractive shape and an electronic part, said support body comprising an elongate recess which extends to an edge of the customized support body,
- a customized elongate electronic part which fits in the recess and which is movable, wherein the movable electronic part comprises:
   ∘ a UDP comprising:
      - a flash memory chip and
      - an end part comprising metal connector strips,
      wherein the flash memory chip and the end part are integrated into a small flat component, and
   ∘ an electronic part body, which comprises a UDP holding section defining a cavity at one end thereof, wherein the UDP is positioned in the cavity, and wherein the combined end part of the UDP and the UDP holding section form a male USB connector which fits into a female USB port of a computer, and wherein a length of the cavity is less than 50 percent of a length of the movable electronic part,
   wherein the electronic device comprises a coupling via which the movable electronic part is coupled to the support body, the coupling allowing a movement of the movable electronic part relative to the support body from an inoperative position in which the movable electronic part is inside the recess to an operative position and vice versa, wherein an end of the movable electronic part is formed as a male connector constructed to fit in a standard female port of a computer, in particular a female USB port, wherein the male connector is the part of the movable electronic part which is remote from the edge of the customized support body, wherein substantially the entire movable electronic part fits in the recess,
   characterized in that both the customized support body and the electronic part body of the movable electronic part are cut to a customized attractive shape.

The device according to the invention has the same advantages as the method, i.e. it provides a simple, reliable and cost-effective electronic device, in particular an USB memory device. The device can have any shape.

The male connector may in particular fit into a female USB type A port. This may be a female USB 2.0 type A port.

The customized support body and the electronic part may be flat. This is a suitable form for cutting.

When seen in a direction which is orthogonal to an upper flat side of the support body, the recess and the electronic part positioned therein may be visible. The thickness of the electronic part may be less than 3 mm.

In an embodiment, the coupling is a sliding coupling, allowing the customized electronic part to slide into and out of the recess, wherein each side of the recess is formed as a rail, and wherein each side of the customized electronic part forms a slider which is configured to slide through the rails, wherein when seen in front view, the recess has a first, constricted section having a first, constricted width and a second, wider section having a second, greater width, and wherein the customized electronic part has respectively a matching first, constricted section having a first, constricted width and a second wider section having a wider width, thereby creating a form lock which prevents any movement of the customized electronic part relative to the customized support body in a direction which is transverse to a sliding direction.

The form lock advantageously allows sliding of the electronic part while preventing the electronic part from inadvertently falling out of the recess.

In an embodiment, the support body has a greater thickness than the customized electronic part, wherein when seen in top view the recess in the support body does not extend all the way through the support body but ends at a bottom wall which covers at least a part of one side of the recess.

The bottom wall protects the electronic part, in particular the metal connectors.

In an embodiment, a thickness of the support body is between 2.5 and 3.5 mm, in particular 3.1 mm, and the electronic part is flush with the support body in the inoperative position. It was found that this specific dimension is very suitable in combination with a UDP.

In an embodiment, when seen in top view the recess comprises a central part and an outer part, wherein the central part is configured to accommodate the end of the customized electronic part which forms the male USB connector, and wherein the sliding coupling only extends along the outer part, the central part being free of any sliding coupling.

Advantageously, the male connector is kept free of any coupling parts so that it fits into the female port of a computer, in particular a female USB type A port.

In an embodiment, the coupling is a pivot coupling which allows the electronic part to pivot relative to the support body between an inoperative position wherein the electronic part is substantially flush with the support body and an operative position wherein the electronic part is not flush with the support body and the male connector is directed away from the support body.

The outer end of the customized electronic part may be cut substantially flush with an edge of the customized support body. However, the outer end may also protrude somewhat from the recess.

The method is cost-effective because different customized forms can be cut from a same combination of support body and electronic part. In particular a different punching knife can be used for each customized form.

In order to facilitate the cutting of as many different forms as possible from a same support body, the recess may be configured such that the male connector is located centrally in the support body. In case a UDP is used, the electronic parts of the electronic part may be located on a main body adjacent the male USB connector, allowing a substantial portion of the electronic part to be cut off without any damage to the electronic parts.

The method according to the invention may be free of the use of any customized mould for forming the customized form. The customized mould makes existing customized USB memory devices expensive when produced in small series.

The male connector may be a male USB connector which is configured to fit in a female USB type A port. Other types of male USB connectors are also possible.

When the coupling is a sliding coupling and the customized electronic part is in the inserted position, it may remain a separate item from the support body.

In an embodiment, the support body is flat. However, it is conceivable that the support body is non-flat, for instance cylindrical or in another shape. This would still allow a general support body to be created and be used in different customized electronic devices, resulting in an inexpensive customized electronic device.

In an embodiment, both sides of the recess may be covered by a wall.

In an embodiment, the customized form of the electronic device may be an animal, a logo, a text, an action figure, a miniature object, a plant or a fantasy figure.

The combined customized support body and electronic part may be provided with a print which matches the customized form of the combined support body and electronic part.

The electronic part may comprise a UDP and an electronic part body. A UDP is an abbreviation for Usb Disk in Package, and indicates that the USB connector and the memory chip are provided as a small, integral component. The UDP comprises all the required components, i.e. the connector strips, a controller, a flash memory IC, and passive components.

The USB Disk In Package is manufactured in an assembly process wherein the USB connector strips and the electronics, in particular the flash memory drive, are integrated into a very small component.

The UDP may be waterproof, dust-free, resistant to dropping and ESD-proof.

The storage capacity may be 1GB, 2GB, 4GB, 8GB, 16GB or higher. There may be 4 metal connector strips.

The UDP may have a thickness of 1.2 -1.6 mm in particular 1.4 mm. The UDP may have a width of 10.5 -12.5 mm in particular 11.3 mm. The UDP may have a length of 15-30 mm, in particular 24.8 mm.

In an embodiment, the support body and the electronic part further comprise a click-coupling allowing the electronic part to be locked in the inserted position while allowing the user to remove the electronic part from the recess by unclicking the electronic part from the support body, wherein the click-coupling preferably comprises:
a) at least one notch protruding from a side of the recess, and at least one recess in a side of the USB-stick configured to accommodate the notch, or
b) at least one notch protruding from a side of the electronic part, and at least one click recess in the support body configured to accommodate the notch.

In a suitable embodiment, the upper and lower sides of the support body and the upper side of the electronic part may be provided with hardened layers of a mixture of resin and hardener, also called domings. The domings may be provided after the cutting operation. In particular three domings may be provided: 1) a doming on the lower side of the support body, 2) a doming on the upper side of the support body and 3) a doming on the upper side of the electronic part.

The domings may be formed directly on the upper and lower sides, or may be formed on separate films which have a same customized form as the support body and the electronic part. The films are then attached to the support body and the electronic part. The edges of the domings may be rounded in an attractive way.

The side of the electronic part which faces the bottom wall and has the metal connectors will remain free of any doming.

The upper side of the customized electronic device may be covered with a doming which is manufactured as a single part and subsequently cut into a support body doming section and an electronic part doming section. Alternatively, the upper side may be covered with two separate domings, a first doming for the support body and a second doming for the electronic part.

In another aspect, the invention relates to a method of manufacturing a customized electronic device, in particular an USB memory device, the method comprising:
- providing a flat piece of support body material,
- cutting a customized support body from the piece, the customized support body having an attractive shape and being suitable for promotional use, the customized support body comprising a recess, the recess being configured for partially accommodating an electronic part having a male connector constructed to fit in a standard female port of a computer, in particular a female USB port, wherein a section of the electronic part fits in the recess and wherein the male connector remains outside the recess,
- providing the electronic part and positioning the electronic part in the recess, wherein the male USB-connector protrudes from the recess,
- providing a first film layer and a second film layer and cutting the first and second film layer in the same customized form as the combined support body and the electronic part,
- covering the first film layer and second film layers with a mixture of resin and hardener on the outer side and letting the mixtures harden in order to form hardened resin domes,
- attaching the combination of the first film layer and the hardened resin dome to one side of the combined support body and the electronic part, wherein the hardened resin dome is positioned on the outer side, and attaching the combination of the second film layer and the hardened resin dome to the opposite side of the combined support body and the electronic part, wherein the hardened resin dome of the second film layer is positioned on the outer side, wherein the combined first film layer and first doming and the combined second film layer and second doming connect the customized support body and the electronic part with one another
the method further comprising manufacturing customized electronic devices having different customized shapes by cutting different customized forms from a same flat piece of support body material, the method being free of the use of any customized mould for forming the customized form.

The method provides another cost-effective way of manufacturing a customized electronic device. The customized electronic device is manufactured in a simple method using standard parts and materials, yet may have an individualized and attractive appearance. The hardened resin domes provide an attractive appearance to the USB memory device.

When seen in top view the recess may extend through the entire support body. This recess may be manufactured in a simple punching operation or with a simple cutting operation, and without a mould. The film layers are attached to the support body and to the electronic part. The film layers interconnect these two parts. Advantageously, a simple yet effective device is obtained with a very limited number of parts. This device can be produced at substantially lest costs than the devices of the prior art.

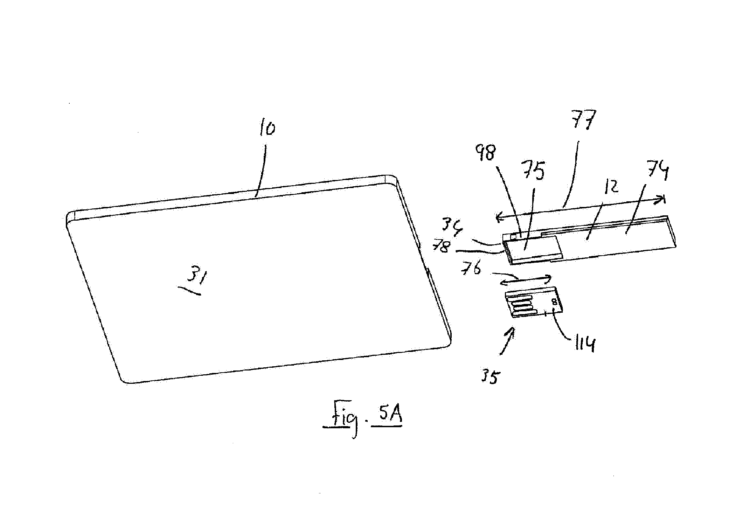

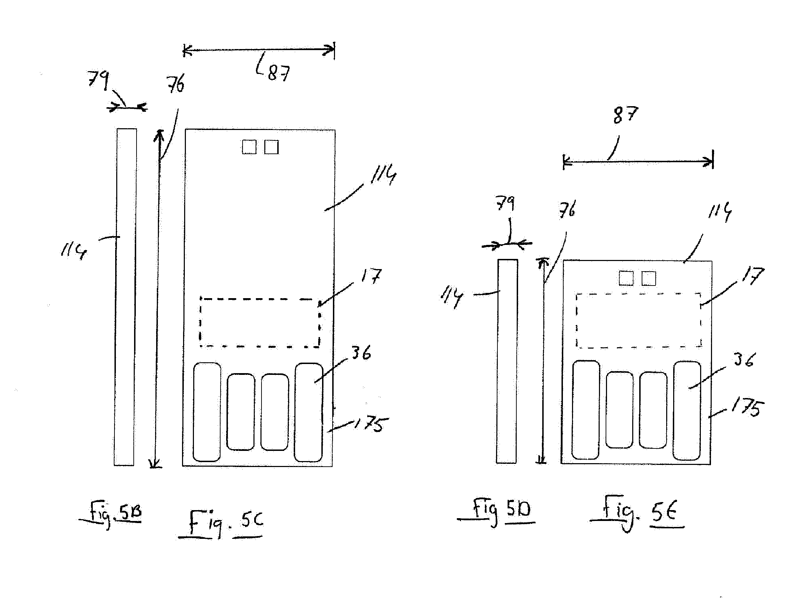

US2008/179424A1 discloses an USB device for emitting a fragrance. The device comprises three cardboard layers 4, 5 and 6, see figure 5. The device does not comprise any film layers with domings. Even if the device would be provided on either side with film layers and domings, then these film layers would not contact the electronic part.

The support body may be manufactured from a semi-rigid or non-rigid, resilient material.

In a suitable embodiment, the domes provide rigidity to the customized electronic device. In particular when the material of the support body is non-rigid, the support body in itself provides little rigidity. The function of providing rigidity is taken over by the domings.

In an embodiment of the method the electronic part comprises:
- a UDP comprising:
   - a flash memory chip and
   - an end part comprising metal connector strips,
   wherein the flash memory chip and the end part are integrated into a small flat component, and
- a UDP holder which comprises a cavity in which the UDP fits, wherein the UDP holder has an open end through which the UDP can be inserted into the cavity, wherein the UDP holder has a main section and an end part holding section having an opening via which the metal connector strips of the UDP are accessible by female connector strips of a female USB port of a computer, wherein the combined end part of the UDP and end part holding section of the UDP holder form a male USB connector which fits in a female USB connector, the method comprising fixing the UDP holder and the support body to one another.

In an embodiment, the method comprises punching the first support body from a larger piece of support material with a punching knife, wherein the film layers are covered with the resin mixture prior to the attaching of the film layers to the combined support body and electronic part, wherein the customized form of the electronic device is an animal, a logo, a text, an action figure, a miniature object, a plant or a fantasy figure, and wherein preferably the first and/or second film layer is provided with an image of an animal, a logo, a text, an action figure, a miniature object, a plant or a fantasy figure or other visual sign.

In an embodiment, the method comprises:
- providing a piece of support body material for a second customized support body,
- cutting the second customized support body from the piece, the second support body being suitable for promotional use, the second customized support body comprising a recess configured for accommodating a cap of the electronic part,
- providing a cap for the electronic part, and positioning the cap in the second recess,
- providing a third film layer and a fourth film layer, cutting the third and fourth film layer in the same form as the combined second support body and the cap,
- covering the third and fourth film layers with a mixture of resin and hardener, and letting the mixtures harden into hardened resin domes,
- attaching the combination of the third film layer and the hardened resin dome to one side of the combined second support body and the cap, and attaching the combination of the fourth film layer and the hardened resin dome to the opposite side of the combined support body and the cap, wherein the hardened resin dome is provided on the outer side of the film layers and provides rigidity to the customized electronic device.

The main part in combination with the cap part provides an attractive electronic device.

In an embodiment, the cap is constructed to fit over the male USB connector.

In an embodiment, the method comprises punching the second support body from a larger piece of support material with a punching knife. Punching was found to be very reliable and cost-effective.

The film layers may be printed stickers.

The invention further relates to a customized electronic device, comprising:
- an electronic part comprising a main section and a male connector constructed to fit in a standard female port of a computer, in particular a female USB port,
- a flat support body having an attractive shape and being suitable for promotional use, said flat support body comprising a recess, the recess being configured for partially housing the electronic part, wherein the recess has a width and length which corresponds to a width and length of the main section of the electronic part such that the main section fits in the recess, wherein the male connector remains outside the recess and protrudes from the recess,
- a first film layer and a second film layer which have a same customized form as the combined support body and main section of the electronic part,
- a first hardened resin dome which covers both the first film layer and a second hardened resin dome which covers the second film layer, wherein the combination of the first film layer and the first hardened resin dome is attached to one side of the combined support body and the electronic part, and wherein

the combination of the second film layer and the second hardened resin dome is attached to the opposite side of the combined support body and the electronic part, the hardened resin domes being provided on the outside, wherein the hardened resin domes provide rigidity to the customized electronic device.

In an embodiment, the electronic part comprises:
- a UDP comprising:
   - a flash memory chip and
   - an end part comprising metal connector strips,
   wherein the flash memory chip and the end part are integrated into a small flat component, and
- a UDP holder which comprises a cavity in which the UDP fits, wherein the UDP holder has an open end through which the UDP can be inserted into the cavity, wherein the UDP holder has a main section and an end part holding section having an opening via which the metal connector strips of the UDP are accessible by female connector strips of a female USB port of a computer, wherein the combined end part of the UDP and the end part holding section of the UDP holder form a male USB connector which fits in a female USB connector,
wherein the recess has a width and a length which corresponds to a width and length of the main section such that the main section fits in the recess.

With the UDP in combination with the other parts, advantageously a cost-effective customized electronic device can be manufactured.

The male connector may be free of any metal housing which extends around the male connector and which defines a cavity above the metal connector strips as is known for male USB plugs.

The customized electronic device may comprise a cap part which comprises:
- a second flat customized support body having an attractive shape which matches the attractive shape of the first part, the second customized support body comprising a second recess, the second recess extending through the entire thickness of the second support body,
- wherein a cap of the electronic part is positioned in the second recess,
- a third film layer and a fourth film layer which have the same form as the combined second support body and the cap and which are attached to the combination of the second support body and the cap,
- a third and fourth hardened resin dome which are attached to respectively the third and fourth film layer,
wherein the combination of the third film layer and the third hardened resin dome is attached to one side of the combined second support body and cap, and wherein the combination of the fourth film layer and the fourth hardened resin dome is attached to the opposite side of the combined second support body and the cap, wherein the hardened resin dome is provided on the outer side of the film layers and wherein the combined first film layer and first doming and the combined second film layer and second doming connect the customized support body and the electronic part with one another.

The cap part fits on the main part and together an attractive electronic device is formed which can be manufactured in a cost-efficient manner.

The first and second film layers may be stickers which are provided with an adhesive on one side and attached to the combined electronic part and support body, and if a cap part is present, wherein the third and fourth film layers are attached to the combined cap and the second support body.

The first and second film layers, and, if a cap part is present, the third and fourth film layers, may be provided with an image which matches the customized form of the combined support body and electronic part, respectively matches the customized form of the combined second support body and cap.

The piece of support body material may be tailored to specific desires. For instance, the piece may be provided in a small size, a medium size and a large size for manufacturing respectively small, medium and large size USB sticks.

The material of the support body may be a synthetic material such as PP, PE, PVC, Nylon or another suitable material. Natural materials such as wood are also conceivable.

The support body may be manufactured using a general mould and injecting a material into the mould, followed by hardening of the material. The electronic part which fits into the recess may also be manufactured using a general mould and injecting a material into the mould, followed by hardening of the material.

A difference between these moulds and the moulds of the known customized USB devices, is that the mould for the present invention is a general mould which may be used for different customized electronic devices. The mould does not produce the end product, but produces an intermediate product having a general shape, for instance an elongate shape, a circular shape, or a square shape. A same mould may therefore be used to create the intermediate product for different end products, i.e. for different customized USB-products. In the known USB memory devices, complicated customized moulds are used which are expensive.

The shape of the end product may be determined by the shape of the cutting organ. Cutting organs may be relatively inexpensive to manufacture. The cutting organ may be configured for a punching operation, i.e. for punching the final form from the combination of the first and electronic part. Other cutting operations are also possible as discussed above.

The customized electronic device may have a shape of an animal, logo, text, action figure, object, plant or fantasy figure.

### List of figures

Embodiments of the customized electronic device according to the invention will be described by way of example only, with reference to the accompanying schematic drawings in which corresponding reference symbols indicate corresponding parts, and in which:
Figure 1 shows an isometric view from above of a support body and an electronic part.
Figure 2 shows an isometric view from above of a support body and an electronic part, wherein the electronic part is moved to an outward position.
Figure 3 shows an isometric view from below of a support body and an electronic part wherein the electronic part is completely removed.
Figure 4 shows an isometric view from above of a support body and an electronic part, wherein the electronic part is completely removed.
Figure 5A shows another isometric view from below of a support body and an electronic part.
Figure 5B shows a side view of a UDP.
Figure 5C shows a top view of a UDP.
Figure 5D shows another side view of a UDP.
Figure 5E shows another top view of a UDP.

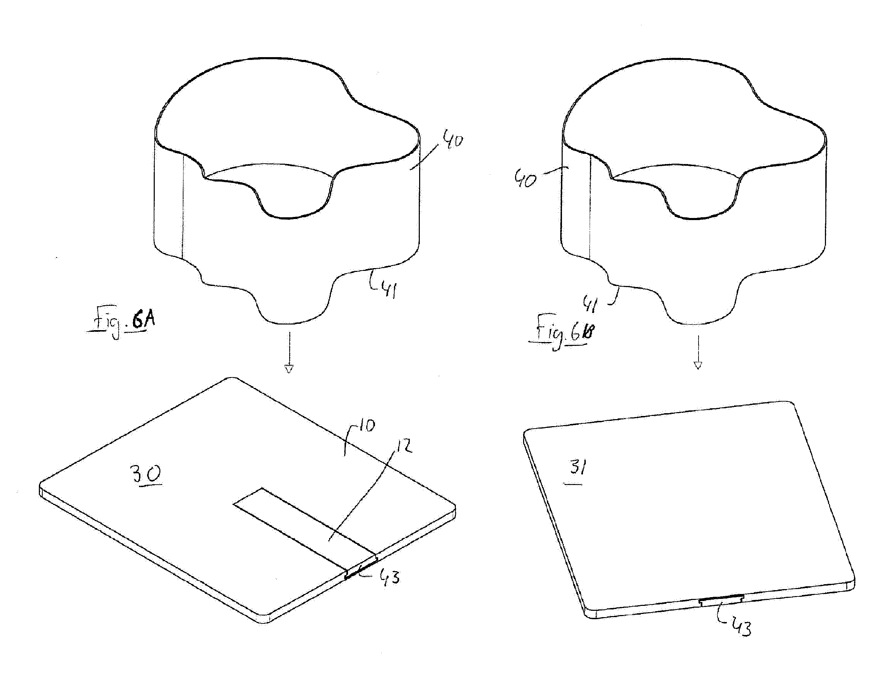

Figure 6A shows an isometric view from above of a support body and an electronic part and a punching knife.
Figure 6B shows an isometric view from below of a support body and an electronic part and a punching knife.

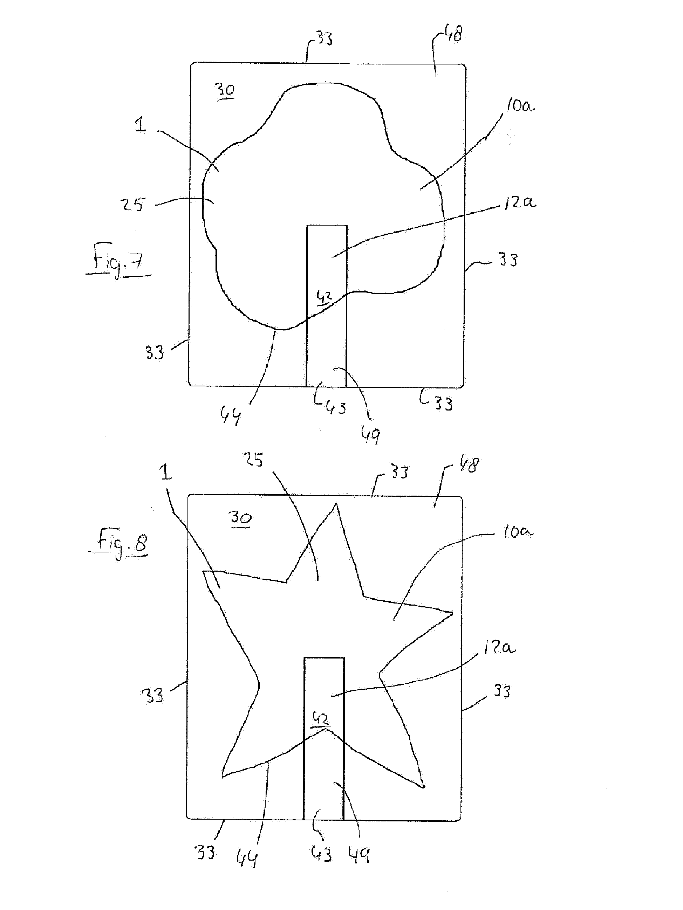

Figure 7 shows a schematic top view of a customized form of a USB-memory device according to the invention.
Figure 8 shows a schematic top view of another customized form of a USB-memory device according to the invention.

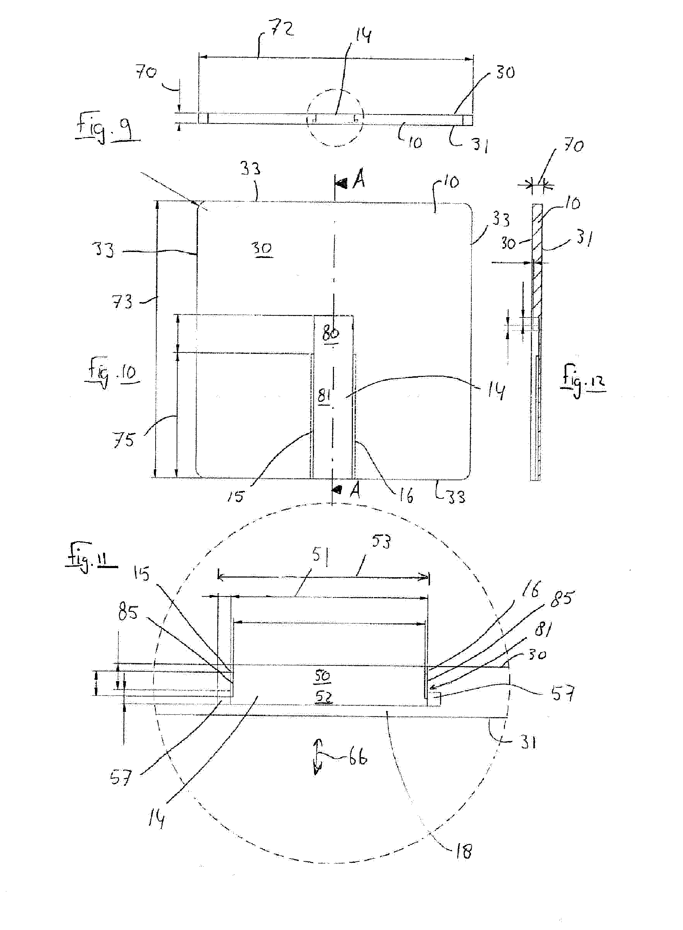

Figure 9 shows a front view of a support body.
Figure 10 shows a top view of a support body.
Figure 11 shows a detailed from view of a support body.
Figure 12 shows a cross section along the line A-A in figure 10.
Figure 13 shows a bottom view of an electronic part according to the invention.
Figure 14 shows a top view of an electronic part according to the invention.
Figure 15 shows a side view of an electronic part according to the invention.
Figure 16 shows a front view of the electronic part according to the invention.

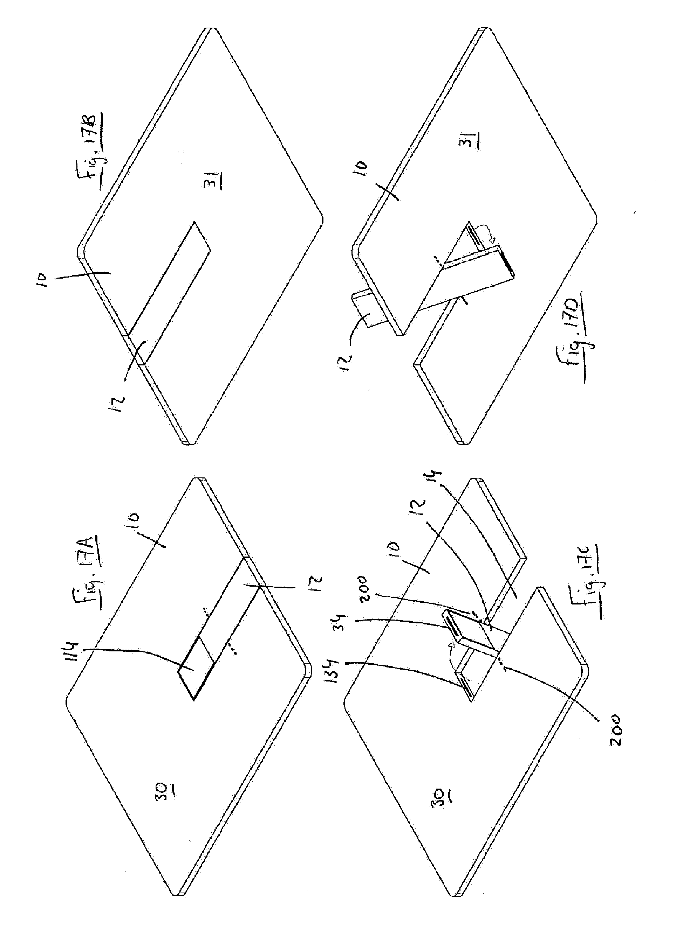

Figures 17A, 17B, 17C, 17D show isometric views of another embodiment according to the invention.

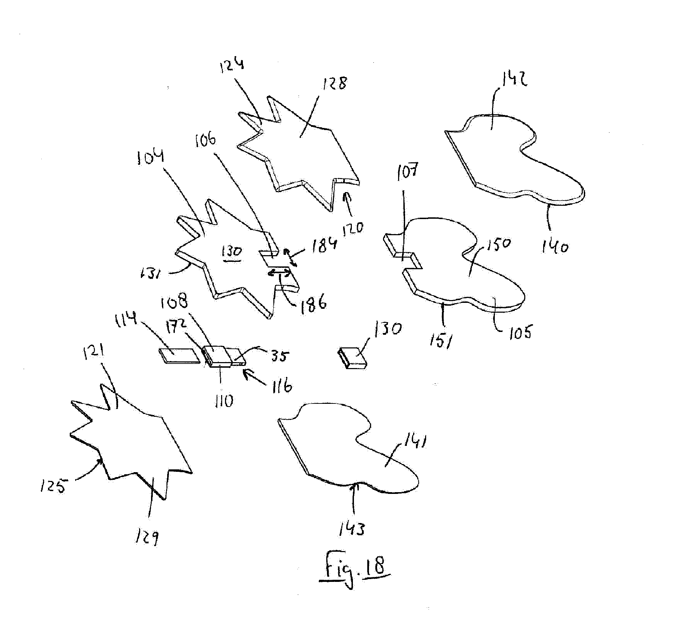

Figure 18 shows an exploded isometric view of a customized electronic device in another aspect of the invention.

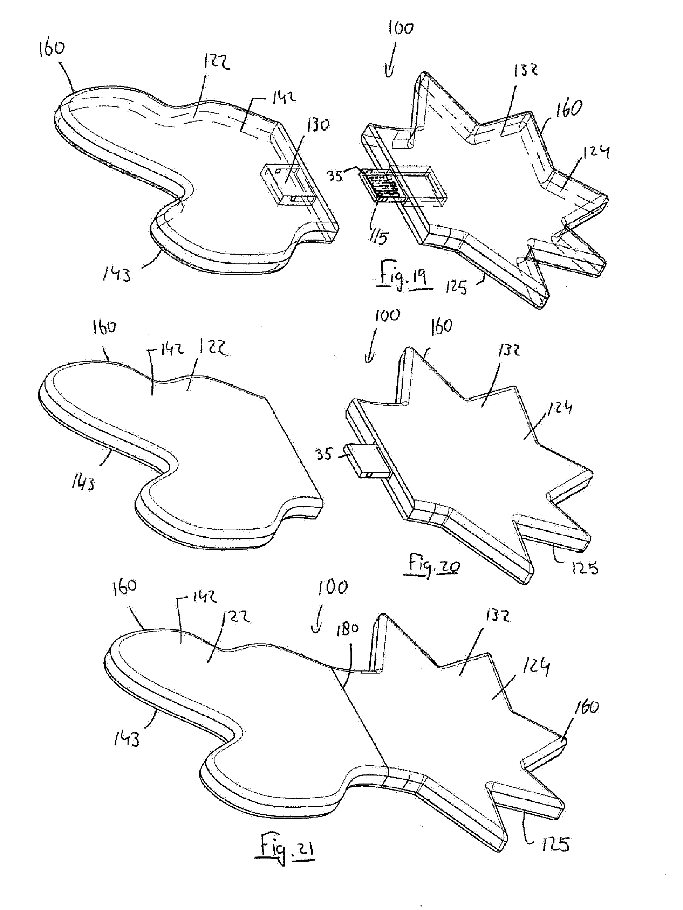

Figure 19 shows an isometric see through image of the customized electronic device.
Figure 20 shows an isometric view of the customized electronic device in an open condition.
Figure 21 shows an isometric view of the customized electronic device in a closed condition.

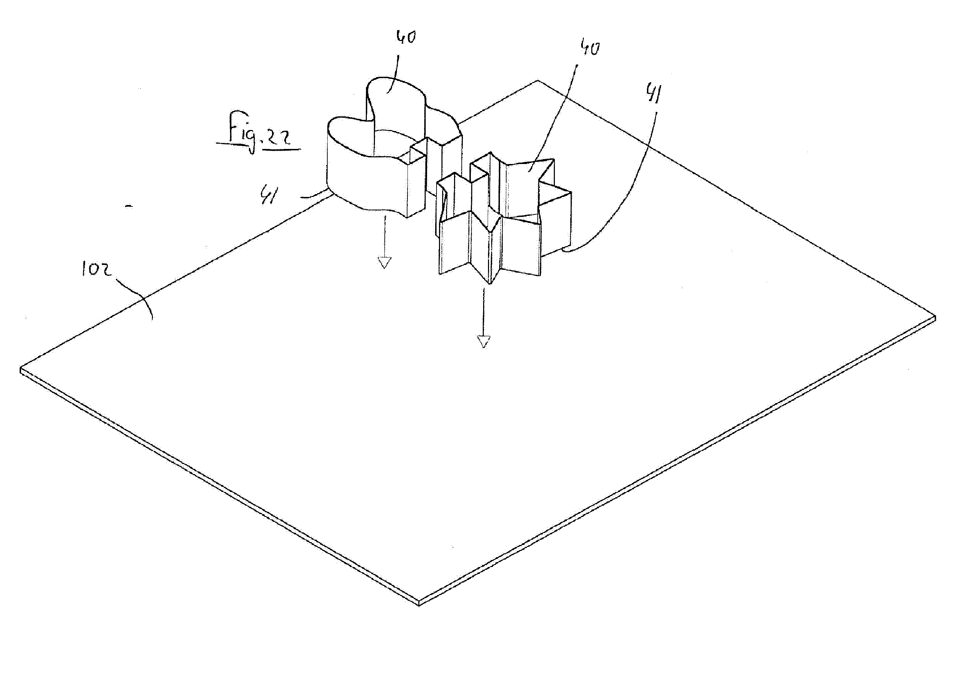

Figure 22 shows an isometric view of a punching operation for manufacturing the support bodies of the customized electronic device according to the second aspect of the invention.

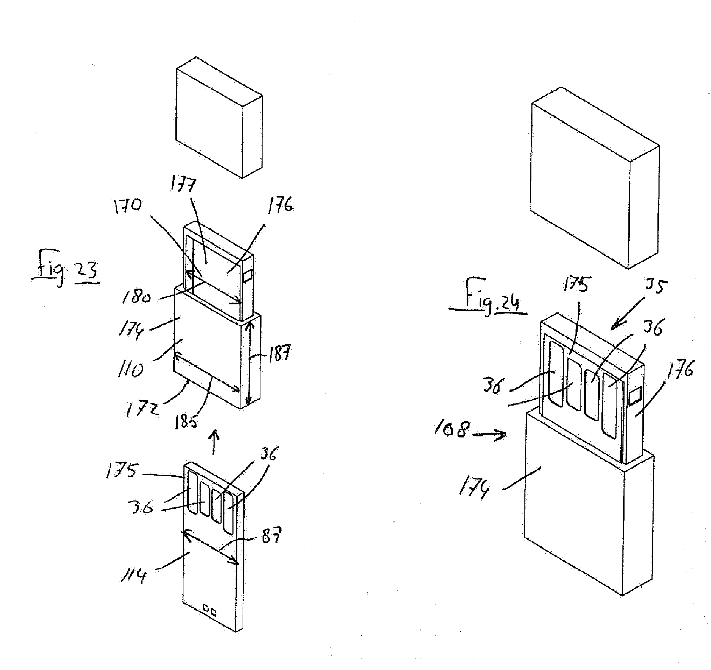

Figure 23 shows a combination of a UDP holder and a UDP when taken apart.
Figure 24 shows a combination of a UDP holder and a UDP when put together.

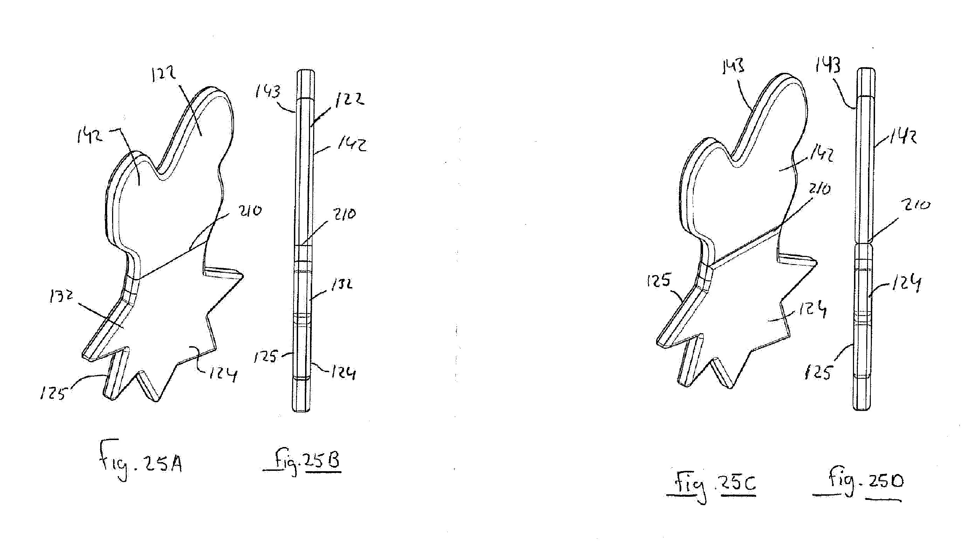

Figure 25A shows an isometric view of the customized electronic device according to the second aspect of the invention.
Figure 25B shows a side view of the embodiment of figure 25A.
Figure 25C shows an isometric view of another embodiment of the customized electronic device according to the second aspect of the invention.
Figure 25D shows a side view of the embodiment of figure 25C.

### Detailed description of the figures

Turning to figures 1, 2, 3, 4, 5A, 5B, 5C, 5D and 5E, the customized electronic device 1 according to the invention may in particular be a customized USB memory device 1. The customized electronic device 1 is manufactured from a general support body 10 and an movable electronic part 12. The support body is flat. The support body has a general, non-customized form, for instance a square shape. Other shapes are also possible, such as non-flat, and non-square shapes. The support body has a top side 30 and a bottom side 31 and four edges 33. The four corners are rounded.

The support body may be formed in a mould or be cut from a large plate material. The support body may be manufactured from a synthetic material, such as PVC, nylon, or PP. Non-synthetic materials are also possible, such as wood or metal. The support body may have a size of 10 x 10 cm, and the recess for the electronic part can be formed in the moulding process.

The support body comprises a recess 14. The recess 14 is elongate and rectangular. The recess 14 has a straight left side 15 and a straight right side 16. It is conceivable that the recess would be arc-shaped in another embodiment. The recess 14 does not extend all the way through the support body, but a wall 18 covers one side of the recess. The wall 18 may only cover a part of the recess. In another embodiment, the wall may be left out.

It is conceivable that a similar wall 18 is provided on the other side, so that the recess is covered on both sides by walls 18 and only has an opening at the edge 33 of the support body. In this way, the electronic part would be concealed and largely invisible.

The recess 14 is configured to accommodate the movable electronic part 12. The sides 21, 22 of the electronic part and the sides 15, 16 of the support body are configured to form a sliding coupling 24, allowing the electronic part to slide into and out of the recess in a direction 68.

An end 34 of the movable electronic part 12 is formed as a male USB connector 35 comprising metal connector strips 36. The male USB connector is configured to fit in a female USB type A port. The male USB connector may also fit in other types of female USB-connectors such as USB 2.0 Type B, USB 2.0 mini type B4, USB 2.0 mini type B5, micro B, USB 3.0 Type A, USB 3.0 type B, USB 3.0 micro type B. The male USB connector may fit in older and newer to be developed, USB female connector types that are (backwards) compatible with the male USB connector. The present invention may be adapted to fit in later developed female USB connector types.

Turning to figure 5A, the movable electronic part 12 comprises an electronic part body 74 and a UDP 114. The electronic part body 74 has a UDP holding section 98 which comprises a cavity 75 in which the UDP 114 fits. The electronic part body may be manufactured from a standard synthetic material, such as PP, PE, Nylon or a similar material. The electronic part body 74 has walls 78 around the cavity 75 to firmly hold the UDP. The electronic part body is rectangular when seen in top view. The male connector 35 is formed by the UDP holding section 98 and an end part 175 of the UDP 114.

The UDP is a very small component and has a length 76 which spans a limited portion of a length 77 of the electronic part body 74, in particular less than 50 percent. This means that all the electronics of the movable electronic part 12 are located in said less than 50 percent. The length of the UDP may be less than one third of the length of the electronic part body. The remainder of the electronic part body 74 therefore can be shortened in a cutting operation without any damage to the functioning of the movable electronic part 12.

Turning to figures 5B, 5C, 5D and 5E, the UDP 114 comprises a flash memory chip 17, which is situated underneath the surface of the UDP. The UDP further comprises four metal connector strips 36. The UDP is small and has a thickness 79 of 1.4 mm. The UDP has a width of 11.3 mm. In figures 5b, 5C, the UDP has a length 76 of 24.8 mm, which is a standard UDP. The UDP may also be extra short, as shown in figures 5D and 5E. This is a micro UDP.

The male USB connector 35 is free of any metal housing which are often provided for male USB connectors which fit in a female USB 2.0 type A port.

In the manufacturing process of the customized electronic device, the movable electronic part 12 is inserted into the recess of the support body. The male USB connector 35 forms the first part which is inserted into the recess, i.e. the end which is furthest from the edge 33 from which the recess starts.

Turning to figures 6A and 6B, in a next step, the combination of the support body 10 and the movable electronic part 12 is cut into a customized form with a cutting device 40, resulting in a customized electronic device, in particular a customized USB memory device, having a customized form and comprising an electronic part which can be moved into and out of the recess by a user. The waste material 48 of the support body and the waste material 49 of the electronic part may be discarded.

The cutting device 40 may comprise a punching knife 41 with which the customized form 25 is punched out of the combination of the support body 10 and the movable electronic part 12.

The cutting device may have various shapes, such as an animal, a logo, a text, an action figure, a miniature object, a plant or a fantasy figure. The cutting operation may be performed from the top side 30 or from the bottom side 31. It is noted that the support body 10 and the movable electronic part 12 may also be cut separately.

Turning to figures 7 and 8, different customized electronic devices 1 may be formed by cutting different customized forms 25 from a same support body 10 and a same movable electronic part 12. This allows the production of relatively small series of customized electronic devices 1, because each time only a punching knife or other cutting device needs to be reconfigured. The mould for producing the support body 10 can remain the same. This provides a substantial saving in costs.

In the resulting customized electronic device 1, an outer end 42 of the customized movable electronic part 12a is cut substantially flush with an edge 44 of the customized support body 10a. It will be clear that the outer end 42 of the customized movable electronic part 12a (i.e. after cutting) need not be the same as the outer end 43 of the movable electronic part 12 before cutting, because the end 43 may be cut off by the cutting device 40, together with a part of the support body 10.

Turning to figures 9, 10 ,11, 12 and 13, each side 15, 16 of the recess is formed as a rail. Each side 21, 22 of the electronic part forms a slider which is configured to slide through the rails.

A thickness 70 of the support body is between 2.5 and 3.5 mm, in particular 3.1 mm. A width 72 and length 73 of the support body before cutting may be between 40 and 150 mm, typically about 100mm. A length 77 of the recess and the movable electronic part 12 may lie between 20 and 70 mm.

The support body 10 has a greater thickness than the movable electronic part 12. The recess 14 in the support body does not extend all the way through the support body, but ends at a bottom wall 18 which covers one side of the recess.

Turning in particular to figure 11, when seen in front view, the recess 14 has a first, constricted section 50 having a first, constricted width 51 and a second, wider section 52 having a second, greater width 53. The wider section 52 defines rails in the form of grooves 57 in the sides 15, 16 through which the electronic part slides.

Turning to figure 16, the movable electronic part 12 has a matching first, constricted section 60 having a first, constricted width 61 and a second wider section 62 having a wider width 63. The wider section 62 forms ribs 69 which protrude from the sides 21, 22 and which slide in the grooves 57. The support body and the electronic part create a form lock which prevents any movement of the electronic part relative to the support body in a direction 66 (see figure 11) which is transverse to a sliding direction 68.

The first section 60 has a height 90 and the second section 62 has a height 91.

Turning to figure 10, when seen in top view, the recess 14 comprises a central part 80 and an outer part 81, wherein the central part 80 is configured to accommodate the male USB connector 35. The sliding coupling 24 only extends along the outer part 81. The central part 80 is free of any sliding coupling.

Turning to figures 13, 14, 15 and 16, the movable electronic part 12 is shown. The movable electronic part 12 comprises an electronic part body 74, also indicated as main body 74, and a UDP 114. The UDP is positioned in a cavity 75 which is surrounded on three sides by a wall 78, and on a fourth side by an elongate part of the electronic part body. The male USB connector comprises four metal strips 36. The male USB connector fits in a female USB 2.0 type A port. The male USB connector is free of any metal housing which surrounds the male connector and forms a cavity above the metal connector strips.

The movable electronic part 12 is rectangular. A wider section 62 extends along the main body forms the rails with which the electronic part slides in the recess 14. The electronic part has an overall length 77.

Turning to figures 11 and 15, the support body 10 and the movable electronic part 12 further comprise a click-coupling 84 allowing the electronic part to be locked in the inserted position while allowing the user to remove the electronic part from the recess by unclicking the electronic part. The click-coupling preferably comprises:
a) at least one notch 85 protruding from a side 15 or 16 of the recess, and at least one recess 86 in a side 21 or 22 of the USB-stick configured to accommodate the notch, or
b) at least one notch protruding from a side of the electronic part, and at least one click recess in the support body configured to accommodate the notch.

Other types of click couplings are also possible, such as a magnet coupling comprising two magnet coupling parts or male/ female type click coupling.

Turning to figures 17A, 17B, 17C, 17D another embodiment is shown. This embodiment comprises a customized electronic device 1 having a support body and an movable electronic part 12 which are coupled to one another via a pivot coupling 84, which allows pivoting of the electronic part relative to the support body 10.

The pivot coupling comprises pins 200 which protrude from the side of the electronic part into holes in the sides of the recess 14. The pins are indicated with dashed lines in figure 17C, 17D. The electronic part pivots between an operative position shown in figures 17C, 17D and an inoperative position shown in figure 17A, 17B. In the inoperative position, the movable electronic part 12 is flush with the top side 30 and bottom side 31 of the support body. In the inoperative position, the UDP is located centrally in the support body.

In the operative position, the UDP is directed away from the support body.

A click coupling is provided at the end 34 of the electronic part and the end 134 of the recess. The end of the recess comprises a notch which fits in a recess in the end 34 of the electronic part.

Three domings may be provided on the electronic device:
1) a doming on the lower side 31 of the customized support body 10a,
2) a doming on the upper side 30 of the customized support body 10a and
3) a doming on the upper side 30 of the customized movable electronic part 12a.

Turning to figures 18 through 24, in another aspect, the present invention relates to a method of manufacturing another customized electronic device 100.

The method comprises providing a piece 102 of support body material. The support body material may a plate of any suitable material such as PP, PE, Nylon and other materials. The material may also be a semi-rigid or non-rigid, resilient material.

With reference to in particular figure 22, in a next step, the method comprises cutting a customized support body 104 from the piece 102 of support body material. The customized support body is attractive and suitable for promotional use. The customized support body may be cut with a cutting device 40 comprising a punching knife 41. Other forms of cutting are also possible, such as sawing, milling, laser cutting, cutting with a water jet. When seen in top view, the recess extends through the support body.

The USB-memory device 100 may comprise a customized cap 122 which will be discussed further below.

The customized support body 104 comprises a recess 106 configured for accommodating an electronic part 108. The electronic part 108 comprises a UDP 114 and a UDP holder 110.

Turning to figures 23 and 24, the UDP holder 110 comprises a cavity 170 in which the UDP 114 fits. The UDP holder 110 has an open end 172 through which the UDP can be inserted into the cavity 170. The UDP holder has a main section 174 and an end part holding section 176 having an opening 177 via which the metal connector strips 36 of the UDP are accessible by female connector strips of a female USB port of a computer.

The male USB connector 35 is formed by an end part 175 of the UDP and the end part holding section 176 together.

The male USB connector 35 may be free of any metal housing which surrounds the metal connector strips as is known for male USB connectors. This makes it possible to keep the customized USB memory device very flat.

The recess 106 of the support body has a width 184 and a length 186 which corresponds to a width 185 and length 187 of the main section 174 such that the main section fits in the recess. Other configurations of the electronic part are also possible.

Returning to in particular figure 18, the electronic part 108 is positioned in the recess 106 of the support body, wherein the male USB-connector 35 protrudes from the recess.

Next, a first film layer 120 and a second film layer 121 are provided. The film layers may be stickers with an adhesive on one side. The first and second film layer are cut in the same customized form as the combined support body 104 and the electronic part 108. The film layers may be provided with an image, text, logo, etc., wherein the image or text matches the customized form of the combined support body and the electronic part.

In a next step, the first film layer 120 and second film layer 121 are covered with a mixture 124, 125 of resin and hardener. The mixtures 124, 125 are allowed some time to harden into hardened resin domes. This process is referred to in the field of the art as "doming". The mixtures 124, 125 turn into "domes" 124, 125. The domes 124, 125 are basically layers with rounded edges 160. The domes 124, 125 of resin and hardener stays in shape with rounded edges 160 on the film layers prior to hardening as a result of the surface tension.

The domes 124, 125 are transparent after hardening, so that an image on the film layer remains visible.

Next, the combination 128 of the first film layer 120 and the dome 124 of hardened resin is attached to one side of the combined support body 104 and the electronic part 108, wherein the dome 124 of hardened resin is positioned on the outer side. In other words, the film layer 120 is positioned between the dome 124 and the support body 104.

The combination 129 of the second film layer 121 and the dome 125 of hardened resin is attached to the opposite side 131 of the combined support body 104 and the electronic part 108, wherein the dome 125 of hardened resin of the second film layer is positioned on the outer side. The domes 124, 125 of hardened resin mixtures form the main structural member which provides rigidity to the customized electronic device 100.

In an embodiment, if the support body 104 is manufactured from a non-rigid material or from a semi-rigid material, the hardened resin mixtures forms the only structural member which provides rigidity to the customized electronic device 100.

Generally, the mixtures 124, 125 will be deposited on the film layers 120, 121 and harden prior to the attaching of the combined of the film layers and hardened domes to the support body.

The customized support body of the customized electronic device 100 may be an animal, a logo, a text, an action figure, a miniature object, a plant or a fantasy figure, and wherein preferably the first and/or second film layer is provided with an image of an animal, a logo, a text, an action figure, a miniature object, a plant or a fantasy figure or other visual sign.

In an embodiment, the method may comprise manufacturing a customized cap 122 of the customized electronic device 100. The cap part is manufactured in a similar fashion as the main part 132.

The cap part is cut from a piece 102 of support body material which may be the same as the first support body material prior to cutting.

A second support body 105 in a customized form is cut from the support body material, for instance with a cutting device 40 comprising a punching knife 41. The second support body 105 in customized form is suitable to form a customize cap. The second support body 105 comprises a recess 107 configured for accommodating a cap 130 of the electronic part. The cap 130 is positioned in the second recess 107.

A third film layer 140 and a fourth film layer 141 are provided which are cut in the same form as the combined second support body 105 and the cap 130. The third and fourth film layers are covered with a mixture 142, 143 of resin and hardener, and the mixtures are allowed some time to harden. The combination of the third film layer 140 and the hardened resin dome 142 (the doming 142) is attached to one side 150 of the combined support body and the cap, and the combination of the fourth film layer 141 and the hardened resin 143 (the doming 143) is attached to the opposite side 151 of the combined support body and the cap. The hardened resin is provided on the outer side of the film layers and provides rigidity to the cap part 122.

The cap fits on the male USB connector and creates a transition 210 with the main part.

Turning to figures 25A-25D, and in particular figures 25A, 25B, when the customized electronic device 100 comprises a main part 132 and cap part 122, the support body can initially be cut as a single support body. In a next step, the domings can be manufactured as a single doming on either side. Next, a cutting operation can be carried in which wherein the single support body is cut in two, a support body 104 for the main part 132 and a support body 105 for the cap part 122. At the same time, the single domings on either side are cut in two separate parts, resulting in four domings 124, 125, 142, 143. At the transition 210 between the main part and the cap part, the domings on 124, 142 on one side have a continuous transition, and the same applies for the domings 125, 143 on the opposite side.

Turning to figures 25C, 25D, alternatively, the support bodies are provided as two separate support bodies 104, 105 beforehand. Four domings 124, 125, 142, 143 are made separately. This provides a different shape of the doming at the transition 210 between the main part 132 and the cap part 122. At the transition, the domings 125, 125, 142, 143 have rounded edges.

As required, detailed embodiments of the present invention are disclosed herein; however, it is to be understood that the disclosed embodiments are merely exemplary of the invention, which can be embodied in various forms. Therefore, specific structural and functional details disclosed herein are not to be interpreted as limiting, but merely as a basis for the claims and as a representative basis for teaching one skilled in the art to variously employ the present invention in virtually any appropriately detailed structure. Further, the terms and phrases used herein are not intended to be limiting, but rather, to provide an understandable description of the invention.

The terms "a" or "an", as used herein, are defined as one or more than one. The term plurality, as used herein, is defined as two or more than two. The term another, as used herein, is defined as at least a second or more. The terms including and/or having, as used herein, are defined as comprising (i.e., open language, not excluding other elements or steps). Any reference signs in the claims should not be construed as limiting the scope of the claims or the invention.

The mere fact that certain measures are recited in mutually different dependent claims does not indicate that a combination of these measures cannot be used to advantage.

## Claims

1. Method of manufacturing a customized electronic device (1), in particular an USB memory device (1), the electronic device comprising a customized support body (10a) having a customized, attractive shape and a movable electronic part (12), the method comprising:
- providing a support body (10) having a general, non-customized shape,
wherein said support body comprises a recess (14) configured to accommodate the movable electronic part (12),
- providing the movable electronic part (12) which fits in the recess, wherein the electronic device (1) comprises a coupling (24) via which the movable electronic part is coupled to the support body, the coupling allowing a movement of the movable electronic part relative to the support body from an inoperative position in which the movable electronic part is inside the recess, to an operative position and vice versa, wherein an end of the electronic part is formed as a male connector (35) constructed to fit in a standard female port of a computer, in particular a female USB port,
wherein the movable electronic part comprises:
o a UDP (114) comprising:
• a flash memory chip (17) and
• an end part (175) comprising metal connector strips (36),
wherein the flash memory chip and the end part are integrated into a small flat component, and
∘ an electronic part body (74), which comprises a UDP holding section (98) defining a cavity (75) at one end thereof, wherein the UDP is positioned in the cavity, and wherein the combined end part of the UDP and the UDP holding section form a male USB connector (35) which fits into a female USB port of a computer, and wherein a length of the cavity is less than 50 percent of a length of the electronic part,
- inserting the movable electronic part into the recess of the support body,
wherein the male connector (35) is located centrally in the support body,
- cutting the combination of the support body and the electronic part into a customized form (25) with a cutting device (40),
the method further comprising manufacturing customized electronic devices having different customized shapes (1) by cutting different customized forms (25) from a same general combination of a support body (12) and a movable electronic part (10), the method being free of the use of any customized mould for forming the customized form,
**characterized in that** the method comprises cutting in the electronic part body (74) of the movable electronic part.

2. Method according to claim 1, wherein the coupling is a sliding coupling, allowing the electronic part to slide into and out of the recess, wherein the recess is elongate and extends from a central portion of the support body to an edge (33) of the support body, wherein sides (21, 22) of the electronic part and sides (15,16) of the recess comprise a rib and groove configured to form the sliding coupling (24), allowing the electronic part to be inserted into the recess into the inoperative position and to be removed from the recess to the operative position, wherein the male connector forms the first section of the electronic part which is slid into the recess.

3. Method according to any of the preceding claims, wherein the cutting device (40) comprises a punching knife (41), wherein the support body and the electronic part are flat, and wherein the customized form is punched from the combination of the support body and the inserted electronic part with the punching knife, wherein the punching knife punches through the support body and the electronic part, in particular at the same time in a single punching movement, thereby forming the customized form.

4. Method according to claim 1 or 3, wherein the coupling is a pivot coupling which allows the electronic part to pivot relative to the support body between an inoperative position wherein the electronic part is substantially flush with the support body and an operative position wherein the electronic part is not flush with the support body and the male connector is directed away from the support body.

5. Method according to claim 4, wherein the pivot coupling has an axis of rotation which is parallel to the support body (10).

6. Method according to any of the preceding claims, wherein the end of the customized electronic part (12a) is cut flush with an edge (44) of the customized support body (10a).

7. Method according to claim 6, wherein when seen in top view the recess comprises a central part (80) and an outer part (81), wherein the central part is configured to accommodate the end (34) of the electronic part which forms the male connector (35) when the electronic part is in the inoperative position, and wherein the ribs and grooves only extend along the outer part, the central part being free of any ribs and grooves.

8. Method according to any of the preceding claims, wherein the support body and the electronic part are flat, and wherein the support body has a greater thickness than the electronic part, wherein the recess (14) in the support body does not extend all the way through the support body, but ends at a bottom wall (18) which covers one side of the recess at least partially.

9. Method according to any of the preceding claims, comprising providing domings on the lower side (31) of the customized support body (10a), the upper side (30) of the customized support body (10a) and the upper side of the customized electronic part (12a).

10. Customized electronic device (1), in particular a USB memory device (1), the electronic device comprising:
- a customized support body (10a) having a customized, attractive shape and an electronic part (12), said support body comprising an elongate recess (14) which extends to an edge (44) of the customized support body (10a),
- a customized elongate electronic part (12a) which fits in the recess and which is movable,
wherein the movable electronic part comprises:
∘ a UDP (114) comprising:
• a flash memory chip (17) and
• an end part (175) comprising metal connector strips (36),
wherein the flash memory chip and the end part are integrated into a small flat component, and
∘ an electronic part body (74), which comprises a UDP holding section (98) defining a cavity (75) at one end thereof, wherein the UDP is positioned in the cavity, and wherein the combined end part (175) of the UDP and the UDP holding section form a male USB connector (35) which fits into a female USB port of a computer, and wherein a length of the cavity is less than 50 percent of a length of the movable electronic part,
wherein the electronic device (1) comprises a coupling (24) via which the movable electronic part is coupled to the support body, the coupling allowing a movement of the movable electronic part relative to the support body from an inoperative position in which the movable electronic part is inside the recess to an operative position and vice versa, wherein an end of the movable electronic part is formed as a male connector (35) constructed to fit in a standard female port of a computer, in particular a female USB port, wherein the male connector (35) is the part of the movable electronic part which is remote from the edge (44) of the customized support body, wherein substantially the entire movable electronic part fits in the recess,
**characterized in that** both the customized support body (10a) and the electronic part body (74) of the movable electronic part are cut to a customized attractive shape.

11. Customized electronic device (1) according to any of the previous device claims,
wherein the coupling is a sliding coupling, allowing the customized electronic part to slide into and out of the recess, wherein sides (21, 22) of the electronic part and sides (15,16) of the recess comprise a rib (69) and groove (57) configured to form the sliding coupling (24).

12. Customized electronic device (1) according to any of the previous device claims,
wherein the support body has a greater thickness than the customized electronic part, wherein when seen in top view the recess (14) in the support body does not extend all the way through the support body but ends at a bottom wall (18) which covers one side of the recess.

13. Customized electronic device (1) according to any of the previous device claims,
wherein a thickness (70) of the support body is between 2.5 and 3.5 mm, in particular 3.1 mm and wherein the electronic part is flush with the support body in the inoperative position.

14. Customized electronic device (1) according to any of the previous device claims,
wherein when seen in top view the recess comprises a central part (80) and an outer part (81), wherein the central part is configured to accommodate the end (34) of the customized electronic part which forms the male USB connector (35), and wherein the sliding coupling (24) only extends along the outer part, the central part being free of any sliding coupling.

15. Customized electronic device (1) according to any of claims 10 and 12 - 14, wherein the coupling is a pivot coupling which allows the electronic part to pivot relative to the support body between an inoperative position wherein the electronic part is substantially flush with the support body and an operative position wherein the electronic part is not flush with the support body and the male connector is directed away from the support body.

16. Method of manufacturing a customized electronic device, in particular an USB memory device (100), the method comprising:
- providing a flat piece (102) of support body material,
- cutting a customized support body (104) from the piece (102), the customized support body having an attractive shape and being suitable for promotional use, the customized support body comprising a recess (14), the recess being configured for partially accommodating an electronic part (108) having a male connector (35) constructed to fit in a standard female port of a computer, in particular a female USB port, wherein a main section (174) of the electronic part fits in the recess and wherein the male connector (35) remains outside the recess,
- providing the electronic part (108) and positioning the main section (114) of the electronic part in the recess (106), wherein the male connector (35) protrudes from the recess,
- providing a first film layer (120) and a second film layer (121) and cutting the first and second film layer in the same customized form as the combined support body and the electronic part,
- covering the first film layer and second film layers with a mixture of resin and hardener on the outer side and letting the mixtures harden in order to form hardened resin domes (124, 125),
- attaching the combination of the first film layer and the hardened resin dome to one side (150) of the combined support body and the electronic part, wherein the hardened resin dome is positioned on the outer side, and attaching the combination of the second film layer and the hardened resin dome to the opposite side (151) of the combined support body and the electronic part, wherein the hardened resin dome of the second film layer is positioned on the outer side, wherein the combined first film layer and first doming and the combined second film layer and second doming connect the customized support body and the electronic part with one another,
the method further comprising manufacturing customized electronic devices having different customized shapes by cutting different customized forms from a same flat piece (102) of support body material, the method being free of the use of any customized mould for forming the customized form.

17. Method according to claim 16, wherein the electronic part (108) comprises:
- a UDP (114) comprising:
• a flash memory chip (17) and
• an end part (175) comprising metal connector strips (36),
wherein the flash memory chip and the end part are integrated into a small flat component, and
- a UDP holder (110) which comprises a cavity (170) in which the UDP fits,
wherein the UDP holder has an open end (172) through which the UDP can be inserted into the cavity, wherein the UDP holder has a main section (174) and an end part holding section (176) having an opening (177) via which the metal connector strips of the UDP are accessible by female connector strips of a female USB port of a computer, wherein the combined end part (175) of the UDP and the end part holding section (176) of the UDP holder form a male USB connector (35) which fits in a female USB connector,
- wherein the recess has a width (184) and length (186) which corresponds to a width (184) and length (186) of the main section (174) such that the main section fits in the recess,
the method comprising fixing the UDP holder (110) which holds the UDP and the support body (106) to one another with the combined film layers and hardened resin domes.

18. Method according to claim 16 or 17, comprising punching the first support body (104) from a larger piece (102) of support material with a punching knife (41), wherein the film layers are covered with the resin mixture prior to the attaching of the film layers to the combined support body and electronic part, wherein the customized form of the electronic device is an animal, a logo, a text, an action figure, a miniature object, a plant or a fantasy figure, and wherein preferably the first and/or second film layer is provided with a corresponding image of an animal, a logo, a text, an action figure, a miniature object, a plant or a fantasy figure or other visual sign.

19. Method according to any of claims 16 - 18, wherein the material of the support body is non-rigid and wherein the domings provide rigidity to the customize electronic device.

20. Method according to any of claims 16 - 19, comprising manufacturing a cap part (122) of the electronic device, the method comprising:
- providing a piece (102) of support body material for a second customized support body,
- cutting the second customized support body from the piece, the second support body being suitable for promotional use, the second customized support body comprising a recess (107) configured for accommodating a cap (130) of the electronic part,
- providing a cap (130) for the electronic part (108), and positioning the cap in the second recess,
- providing a third film layer (140) and a fourth film layer (141), cutting the third and fourth film layer in the same form as the combined second support body and the cap,
- covering the third and fourth film layers with a mixture of resin and hardener, and letting the mixtures harden into hardened resin domes,
- attaching the combination of the third film layer and the hardened resin dome to one side of the combined second support body and the cap, and attaching the combination of the fourth film layer and the hardened resin dome to the opposite side of the combined support body and the cap, wherein the hardened resin dome is provided on the outer side of the film layers and provides rigidity to the USB memory device.

21. Method according to claim 20 insofar as dependent on claim 18, wherein the cap is constructed to fit over a male connector (35), in particular a male USB connector.

22. Method according to claim 21, comprising punching the second support body (105) from a larger piece of support material with a punching knife (41).

23. Method according to any of method claims 16 - 22, wherein the film layers are printed stickers.

24. Method according to any of claims 16 - 23, wherein the electronic device comprises a main part (132) and a cap part (122), and wherein the method comprises:
- providing a single support body in the combined shape of the main part and the cap part and providing a single doming on either side of the single support body, followed by cutting the single support body and the domings on either side in a main part and a cap part, or
- providing separate support bodies (104, 105) for the main part and the cap part, and providing four separate domings (124,125,142,143) on the sides of the separate support bodies, wherein the domings on either side of a transition between the main part and the cap part have rounded edges.

25. Method according to any of method claims 16 - 24, wherein the recess extends through the entire support body and wherein the film layers are attached to the support body and to the electronic part.

26. Customized electronic device (100), comprising:
- an electronic part (108) comprising a main section (174) and a male connector (35) constructed to fit in a standard female port of a computer, in particular a female USB port,
- a flat support body (104) having an attractive shape and being suitable for promotional use, said flat support body comprising a recess (106), the recess being configured for partially housing the electronic part (108), wherein the recess has a width (184) and length (186) which corresponds to a width (185) and length (187) of the main section (174) of the electronic part such that the main section fits in the recess, wherein the male connector (35) remains outside the recess and protrudes from the recess,
- a first film layer (120) and a second film layer (121) which have a same customized form as the combined support body and main section of the electronic part,
- a first hardened resin dome which covers both the first film layer and a second hardened resin dome which covers the second film layer, wherein the combination of the first film layer (120) and the first hardened resin dome is attached to one side (130) of the combined support body and the electronic part, and wherein the combination of the second film layer (121) and the second hardened resin dome is attached to the opposite side (131) of the combined support body and the electronic part, the hardened resin domes being provided on the outside, wherein the combined first film layer and first doming and the combined second film layer and second doming connect the customized support body and the electronic part with one another.

27. Customized electronic device according to claim 26, wherein the electronic part (108) comprises:
- a UDP (114) comprising:
• a flash memory chip (17) and
• an end part (175) comprising metal connector strips (36),
wherein the flash memory chip and the end part are integrated into a small flat component, and
- a UDP holder (110) which comprises a cavity (170) in which the UDP fits,
wherein the UDP holder has an open end (172) through which the UDP can be inserted into the cavity, wherein the UDP holder has a main section (174) and an end part holding section (176) having an opening (177) via which the metal connector strips of the UDP are accessible by female connector strips of a female USB port of a computer, wherein the combined end part (175) of the UDP and the end part holding section (176) of the UDP holder form a male USB connector (35) which fits in a female USB connector,
- wherein the recess (106) has a width (184) and a length (186) which corresponds to a width (185) and length (187) of the main section (174) such that the main section (174) fits in the recess.

28. Customized electronic device according to claim 26 or 27, wherein the male connector is free of any metal housing which extends around the metal connector strips and which defines a cavity above the metal connector strips (36) as is known for male USB connectors.

29. Customized electronic device according to any of claims 26 - 28, wherein the support body is a non-rigid material and wherein the domings provide rigidity to the customized electronic device.

30. Customized electronic device according to any of claims 26 - 29, comprising a cap part (122) which comprises:
- a second flat customized support body (105) having an attractive shape which matches the attractive shape of the first part, the second customized support body comprising a second recess (107), the second recess extending through the entire thickness of the second support body,
- wherein a cap (130) of the electronic part is positioned in the second recess,
- a third film layer (140) and a fourth film layer (141) which have the same form as the combined second support body and the cap and which are attached to the combination of the second support body and the cap,
- a third and fourth hardened resin dome which are attached to respectively the third and fourth film layer,
wherein the combination of the third film layer and the third hardened resin dome is attached to one side of the combined second support body and cap, and wherein the combination of the fourth film layer and the fourth hardened resin dome is attached to the opposite side of the combined second support body and the cap, wherein the hardened resin dome is provided on the outer side of the film layers and provides rigidity to the cap part of the customized electronic device.

31. Customized electronic device according to any of claims 26 - 30, wherein the first and second film layers are stickers which are provided with an adhesive on one side and attached to the combined electronic part and support body, and insofar as dependent on claim 27, wherein the third and fourth film layers are stickers which are provided with an adhesive on one side and attached to the combined cap and the second support body.

32. Customized electronic device according to any of claims 26 - 31, wherein the first and second film layers, and, if a cap part is present, the third and fourth film layers, are provided with an image which matches the customized form of the combined support body and electronic part, respectively matches the customized form of the combined second support body and cap.

33. Customized electronic device according to any of claims 30 - 32, wherein at a transition between the main part and the cap part, the domings on either side of the transition are provided with rounded edges at the transition or wherein the doming on one side of the transition goes over in the doming on the other side of the transition.

34. Customized electronic device according to any of claims 26 - 33, wherein the recess extends through the entire support body and wherein the film layers are attached to the support body and to the electronic part.
